(19) Europäisches Patentamt
European Patent Office
Office européen des brevets

(11) EP 1 548 150 A1

(12) EUROPEAN PATENT APPLICATION
published in accordance with Art. 158(3) EPC

(43) Date of publication:
**29.06.2005 Bulletin 2005/26**

(21) Application number: **03748631.3**

(22) Date of filing: **01.10.2003**

(51) Int Cl.⁷: **C23C 16/509**, H01L 21/205, H05H 1/46, B01J 19/08

(86) International application number:
**PCT/JP2003/012563**

(87) International publication number:
**WO 2004/031442 (15.04.2004 Gazette 2004/16)**

(84) Designated Contracting States:
**CH DE GB LI**

(30) Priority: **01.10.2002 JP 2002288997**

(71) Applicant: **Mitsubishi Heavy Industries**
**Tokyo 108-8215 (JP)**

(72) Inventors:
- **KAWAMURA, K., Mitsubishi Heavy Industries, Ltd. 5-chome, Nagasaki-shi, Nagasaki 851-0392 (JP)**
- **YAMADA, A., Mitsubishi Heavy Industries, Ltd. 5-chome, Nagasaki-shi, Nagasaki 851-0392 (JP)**
- **MASHIMA, H., Mitsubishi Heavy Industries, Ltd. 5-chome, Nagasaki-shi, Nagasaki 851-0392 (JP)**
- **TAGASHIRA, K., Mitsubishi Heavy Industries, Ltd. 5-chome, Nagasaki-shi, Nagasaki 851-0392 (JP)**
- **TAKEUCHI, Y., Mitsubishi Heavy Industries, Ltd. -machi, Nagasaki-shi, Nagasaki 850-8610 (JP)**

(74) Representative: **HOFFMANN EITLE**
**Arabellastrasse 4**
**81925 München (DE)**

# (54) PLASMA PROCESSING SYSTEM AND ITS SUBSTRATE PROCESSING PROCESS, PLASMA ENHANCED CHEMICAL VAPOR DEPOSITION SYSTEM AND ITS FILM DEPOSITION PROCESS

(57) An object is to provide apparatuses for plasma processing which can make the distribution of the film thickness of a substance on a substrate uniform, methods of processing a substrate therewith, apparatuses for plasma-enhanced chemical vapor deposition, and methods for film formation therewith. When a desired substance is vapor deposited on the surface of a substrate (3), characteristics of the distribution of the thickness of a film on the substrate having a large area are improved by eliminating local imbalance in the distribution of the film thickness originating from deviation in the distribution of voltage on the ladder electrode (2), by way of adjusting impedance matching between each coaxial cable and corresponding feeding point for the ladder-shaped electrode (2) using branch cables provided to the coaxial cables for supplying high-frequency electric power to a ladder-shaped electrode (2) so as to make the film thickness uniform in the direction at right angles with the direction of fed electric power, whereby high-frequency electric power which is fed to each longitudinal electrode rod (2a) of the ladder-shaped electrode (2) can be adjusted, and distribution of voltage at a right or left part of the substrate and distribution of voltage at a central part of the substrate can be balanced, as well as by way of promoting uniformity in the distribution of the film thickness in the direction of fed electric power, by supplying streams of high-frequency electric power having the same frequency from two power supplies to the ladder-shaped electrode (2) with the phase difference between the high-frequency electric powers being varied over time.

FIG. 2

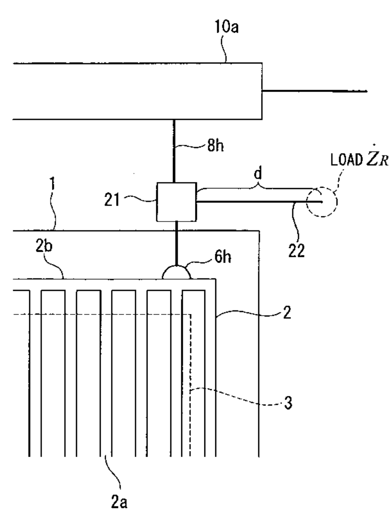


EP 1 548 150 A1

## Description

### TECHNICAL FIELD

The present invention relates to apparatuses for plasma processing which generate plasma and process a substance on a substrate, methods of processing a substrate therewith, apparatuses for plasma-enhanced chemical vapor deposition, and methods for film formation therewith.

### BACKGROUND ART

In order to vapor deposit a substance such as a semiconductor, for example, on a substrate, there have hitherto been apparatuses for plasma-enhanced chemical vapor deposition (plasma CVD apparatus) with which a gas for forming a film containing such a substance is introduced into a vacuum space between the substrate and discharge electrodes which are disposed in parallel with and opposite to the substrate, and at the same time high-frequency electric power is fed to the discharge electrodes to generate plasma between the substrate and the discharge electrodes, and the gas for forming a film containing the substance is decomposed in the plasma so that a target substance is vapor deposited on the substrate (Japanese Patent Application, First Publication (Kokai), No. 2001-274099).

### DISCLOSURE OF INVENTION

However, an apparatus for plasma-enhanced chemical vapor deposition as described above has a problem in that it is difficult to make the distribution of the thickness of a formed film uniform on the entire substrate when the film is formed on a substrate having a large area exceeding, for example, the dimensions (length by breath) of 1 m by 1 m.

Thus, according to the technique described in the above patent document, for example, attempts were made to make the distribution of the film thickness uniform by adjusting the impedances of a plurality of high-frequency cables for feeding electric power to a plurality of discharge electrodes over a substrate to be equal so as to stably supply the high-frequency electric power generated by a high-frequency electric power feeding circuit, and at the same time by supplying the discharge electrodes with two streams of high-frequency electric power having different frequencies, respectively, so as to avoid generation of standing waves, which inhibit provision of uniformity in the film thickness, on the discharge electrodes. However, there has been a problem in that localized imbalance in the distribution of the film thickness occurs due to arrangement of the discharge electrodes, and characteristics of the distribution of the film thickness on a substrate having a large area have not been sufficiently improved.

Especially when ladder-shaped electrodes or mesh electrodes are used as discharge electrodes, a discharge electrode near the central part of the substrate, the discharge electrode being flanked on both sides in the vicinity by other discharge electrodes, and a discharge electrode which is flanked only on the right or left side in the vicinity by another discharge electrode and which is in the vicinity of an end part of the substrate (hereinafter referred to as a right or left part of the substrate), the end part being at an end in a direction at right angles to the direction of fed electric power, have different effects on the substrate due to the difference in arrangements and structures. Therefore, the distribution of the thickness of a vapor deposited film has tended to be nonuniform. Accordingly, to obtain a substrate having a film with a uniform distribution of the desired thickness, it was necessary to carry out a process in which the film is formed on a substrate having a size measurably larger than a substrate of the desired size, giving up right and left parts of the substrate on which the film thickness is deviated, and only the part in which the film thickness is uniform is cut out. In this case, there was a problem in that the yield of substrates on which a substance was vapor deposited is low.

The present invention was conceived in view of the above problems, and an object of the present invention is to provide apparatuses for plasma processing which can readily make the distribution of the film thickness of a substance on a substrate uniform, methods of processing a substrate therewith, apparatuses for plasma-enhanced chemical vapor deposition, and methods for film formation therewith.

In order to solve the above problems, in an apparatus for plasma processing with which high-frequency electric power generated by a high-frequency electric power feeding circuit is fed to a plurality of discharge electrodes, and plasma is generated between the discharge electrodes and a substrate which are in a processing chamber into which a gas for processing has been introduced, so as to process a substance on the substrate, the apparatus for plasma processing according to the present invention comprises a voltage distribution regulator for adjusting deviation in distribution of voltage on the discharge electrodes, the distribution of voltage occurring in a direction at right angles to a direction of fed electric power through the discharge electrodes.

With an apparatus for plasma processing having the above structure, the distribution of voltage at a right or left part of a substrate and the distribution of voltage at a central part of the substrate are balanced, between which otherwise deviation would occur due to the difference in arrangements and structures between a discharge electrode near the central part of the substrate, the discharge electrode being flanked on both sides in the vicinity by other discharge electrodes, and a discharge electrode near a right or left part (which is a substrate end part at an end in a direction at right angles to the direction of fed electric power) of the substrate, this discharge electrode being flanked only on the right or left side in the vicinity by another discharge electrode; the balancing is carried out using a voltage distribution regulator, so that distribution of voltage which is applied between the discharge electrodes and the substrate in order to generate plasma is made uniform over the entirety of the substrate, and the substance of the substrate can be uniformly processed.

Accordingly, an effect is obtained in which characteristics of the distribution of the thickness of a film on a substrate having a large area are improved by eliminating local imbalance in the distribution of the film thickness originating from deviation in the distribution of voltage on the discharge electrodes.

Alternatively, in an apparatus for plasma-enhanced chemical vapor deposition with which high-frequency electric power generated by a high-frequency electric power feeding circuit (for example, electric power dividers 10a and 10b, high-frequency electric power supplies 11a and 11b, and matching boxes 12a and 12b as in "BEST MODE FOR CARRYING OUT THE INVENTION") is fed to a plurality of discharge electrodes, and plasma is generated between the discharge electrodes and a substrate (for example, a substrate 3 as in "BEST MODE FOR CARRYING OUT THE INVENTION") which are in a film formation chamber (for example, a film formation chamber 1 as in "BEST MODE FOR CARRYING OUT THE INVENTION") into which a gas for forming a film containing the desired substance has been introduced, so as to vapor deposit the substance on the substrate, the apparatus for plasma-enhanced chemical vapor deposition according to the present invention comprises a voltage distribution regulator for adjusting deviation in distribution of voltage on the discharge electrodes, the distribution of voltage occurring in a direction at right angles to a direction of fed electric power through the discharge electrodes.

With an apparatus for plasma-enhanced chemical vapor deposition having the above structure, the distribution of voltage at a right or left part of a substrate and the distribution of voltage at a central part of the substrate are balanced, between which otherwise deviation would occur due to the difference in arrangements and structures between a discharge electrode near the central part of the substrate, the discharge electrode being flanked on both sides in the vicinity by other discharge electrodes, and a discharge electrode near a right or left part (which is a substrate end part at an end in a direction at right angles to the direction of fed electric power) of the substrate, this discharge electrode being flanked only on the right or left side in the vicinity by another discharge electrode; the balancing is carried out using a voltage distribution regulator, so that the distribution of voltage which is applied between the discharge electrodes and the substrate in order to generate plasma is made uniform over the entirety of the substrate.

Accordingly, an effect is obtained in which characteristics of the distribution of the thickness of a film on a substrate having a large area are improved by eliminating local imbalance in the distribution of the film thickness originating from deviation in the distribution of voltage on the discharge electrodes, whereby the yield in the production of substrates on which a substance is vapor deposited can be improved, and at the same time the quality of the produced substrates can be improved.

Alternatively, in an apparatus for plasma-enhanced chemical vapor deposition as described above, the apparatus for plasma-enhanced chemical vapor deposition according to the present invention is characterized in that the voltage distribution regulator is an impedance changer which is provided to at least one of a plurality of high-frequency cables (for example, coaxial cables 8a to 8h and coaxial cables 9a to 9h as in "BEST MODE FOR CARRYING OUT THE INVENTION") for supplying high-frequency electric power from the high-frequency electric power feeding circuit to the plurality of discharge electrodes in order to change an impedance at a feeding point (for example, feeding points 6a to 6h and feeding points 7a to 7h as in "BEST MODE FOR CARRYING OUT THE INVENTION") for the discharge electrodes toward the high-frequency electric power feeding circuit.

With an apparatus for plasma-enhanced chemical vapor deposition having the above structure, the impedance changer adjusts impedance matching between each of the plurality of high-frequency cables for supplying high-frequency electric power from the high-frequency electric power feeding circuit to the plurality of discharge electrodes and a corresponding feeding point for the discharge electrodes, whereby high-frequency electric power which is fed to each discharge electrode can be adjusted, and the distribution of voltage at a right or left part of a substrate and the distribution of voltage at a central part of the substrate can be balanced.

Accordingly, an effect is obtained in which characteristics of the distribution of the thickness of a film on a substrate having a large area are improved by easily eliminating deviation in the distribution of voltage on the discharge electrodes by way of voltage adjustment at a feeding point for the discharge electrodes by adjusting impedance matching, whereby the yield in the production of substrates on which a substance is vapor deposited can be improved, and at the same time the quality of the produced substrates can be improved.

Alternatively, in an apparatus for plasma-enhanced chemical vapor deposition as described above, the apparatus for plasma-enhanced chemical vapor deposition according to the present invention is characterized in that the impedance changer is a stub comprising a branch cable (for example, a branch 22 as in "BEST MODE FOR CARRYING OUT THE INVENTION") which branches off from the high-frequency cable.

With an apparatus for plasma-enhanced chemical vapor deposition having the above structure, the stub adjusts impedance matching between each of the plurality of high-frequency cables for supplying high-frequency electric power to the plurality of discharge electrodes and a corresponding feeding point for the discharge electrodes, whereby high-frequency electric power which is fed to each discharge electrode can be easily adjusted, and the distribution of voltage at a right or left part of a substrate and the distribution of voltage at a central part of the substrate can be balanced.

Accordingly, an effect is obtained in which installation of the branch cable, which constitutes the stub, outside the film formation chamber could allow adjustment of the high-frequency electric power which is fed to each discharge electrode without affecting the condition in the film formation chamber, whereby the yield in the production of substrates on which a substance is vapor deposited can be further improved, and at the same time the quality of the produced substrates can be improved.

Alternatively, in an apparatus for plasma-enhanced chemical vapor deposition as described above, the apparatus for plasma-enhanced chemical vapor deposition according to the present invention is characterized in that the stub comprises a passive element which is connected to a distal end of the branch cable, and, with change in a constant of the passive element, the stub changes the impedance at a feeding point for the discharge electrodes toward the high-frequency electric power feeding circuit.

With an apparatus for plasma-enhanced chemical vapor deposition having the above structure, the impedance of the stub can be freely set by the way of selecting a constant of the passive element.

Accordingly, an effect is obtained in which the distribution of voltage at a right or left part of a substrate and the distribution of voltage at a central part of the substrate can be balanced, and precision in the characteristics of the distribution of the film thickness on a substrate having a large area can be improved, by easily and precisely setting an impedance of the stub corresponding to the deviation in the distribution of voltage on the discharge electrodes.

Alternatively, in an apparatus for plasma-enhanced chemical vapor deposition as described above, the apparatus for plasma-enhanced chemical vapor deposition according to the present invention is characterized in that, with change in the cable length of the branch cable, the stub changes the impedance at a feeding point for the discharge electrodes toward the high-frequency electric power feeding circuit.

With an apparatus for plasma-enhanced chemical vapor deposition having the above structure, the impedance of the stub can be freely set by the way of selecting the cable length of the branch cable.

Accordingly, an effect is obtained in which the distribution of voltage at a right or left part of a substrate and the distribution of voltage at a central part of the substrate can be balanced, and precision in the characteristics of the distribution of the film thickness on a substrate having a large area can be improved, by precisely setting the impedance of the stub corresponding to the deviation in the distribution of voltage on the discharge electrodes without incurring additional cost.

Alternatively, in an apparatus for plasma-enhanced chemical vapor deposition as described above, the apparatus for plasma-enhanced chemical vapor deposition according to the present invention is characterized in that, with change in the characteristic impedance of the branch cable itself, the stub changes the impedance at a feeding point for the discharge electrodes toward the high-frequency electric power feeding circuit.

With an apparatus for plasma-enhanced chemical vapor deposition having the above structure, the impedance of the stub can be freely set by the way of selecting the characteristic impedance of the branch cable itself.

Accordingly, an effect is obtained in which the distribution of voltage at a right or left part of a substrate and the distribution of voltage at a central part of the substrate can be balanced, and precision in the characteristics of the distribution of the film thickness on a substrate having a large area can be improved, by precisely setting the impedance of the stub without incurring additional cost.

Alternatively, in an apparatus for plasma-enhanced chemical vapor deposition as described above, the apparatus for plasma-enhanced chemical vapor deposition according to the present invention is characterized in that the voltage distribution regulator is an impedance changer which is provided between the discharge electrodes and a grounding point in order to change the impedance at a feeding point for the discharge electrodes toward the discharge electrodes.

With an apparatus for plasma-enhanced chemical vapor deposition having the above structure, the impedance changer directly changes the impedance of the discharge electrodes, whereby high-frequency electric power which is fed to each discharge electrode can be adjusted, and the distribution of voltage at a right or left part of a substrate and the distribution of voltage at a central part of the substrate can be balanced.

Accordingly, an effect is obtained in which characteristics of the distribution of the thickness of a film on a substrate having a large area are improved by easily eliminating deviation in the distribution of voltage on the discharge electrodes by way of voltage adjustment of the discharge electrodes by adjusting the impedance of the discharge electrodes, whereby the yield in the production of substrates on which a substance is vapor deposited can be improved, and at the same time the quality of the produced substrates can be improved.

Alternatively, in an apparatus for plasma-enhanced chemical vapor deposition as described above, the apparatus for plasma-enhanced chemical vapor deposition according to the present invention is characterized in that the impedance changer comprises a passive element (for example, terminal coils 31a to 31d as in "BEST MODE FOR CARRYING OUT THE INVENTION") which is connected between the discharge electrodes and the grounding point, and, with change in a constant of the passive element, the impedance changer changes the impedance between the discharge electrodes and the grounding point.

With an apparatus for plasma-enhanced chemical vapor deposition having the above structure, the impedance between the discharge electrodes and the grounding point can be freely set by the way of selecting a constant of the passive element.

Accordingly, an effect is obtained in which the distribution of voltage at a right or left part of a substrate and the distribution of voltage at a central part of the substrate can be balanced, and precision in the characteristics of the distribution of the film thickness on a substrate having a large area can be improved, by easily and precisely setting the impedance between the discharge electrodes and the grounding point corresponding to the deviation in the distribution of voltage on the discharge electrodes.

In a method of processing a substrate with an apparatus for plasma processing by feeding high-frequency electric power generated by a high-frequency electric power feeding circuit to a plurality of discharge electrodes, and generating plasma between the discharge electrodes and a substrate in a processing chamber into which a gas for processing has been introduced, so as to process a substance on the substrate, the method of processing a substrate with an apparatus for plasma processing according to the present invention comprises adjusting deviation in distribution of voltage on the discharge electrodes, the distribution of voltage occurring in a direction at right angles to a direction of fed electric power through the discharge electrodes, whereby distribution of voltage at an end part of the substrate, the end part being at an end in the direction at right angles to the direction of fed electric power, and distribution of voltage at a central part of the substrate are balanced, so that distribution of voltage which is applied between the discharge electrodes and the substrate in order to generate plasma is made uniform over the entirety of the substrate.

With the above method, an apparatus for plasma processing can produce a substrate with a film having a uniform thickness due to the distribution of voltage which is uniformly made over the entirety of the substrate.

Accordingly, an effect is obtained in which characteristics of the distribution of the thickness of a film on a substrate having a large area are improved by eliminating local imbalance in the distribution of the film thickness originating from deviation in the distribution of voltage on the discharge electrodes.

In a method for film formation with an apparatus for plasma-enhanced chemical vapor deposition by feeding high-frequency electric power generated by a high-frequency electric power feeding circuit to a plurality of discharge electrodes, and generating plasma between the discharge electrodes and a substrate in a film formation chamber into which a gas for forming a film has been introduced, so as to vapor deposit the substance on the substrate, the method for film formation with an apparatus for plasma-enhanced chemical vapor deposition according to the present invention comprises adjusting deviation in distribution of voltage on the discharge electrodes, the distribution of voltage occurring in a direction at right angles to the direction of fed electric power through the discharge electrodes, whereby distribution of voltage at an end part of the substrate, the end part being at an end in the direction at right angles to the direction of fed electric power, and distribution of voltage at a central part of the substrate are balanced, so that distribution of voltage which is applied between the discharge electrodes and the substrate in order to generate plasma is made uniform over the entirety of the substrate.

With the above method, an apparatus for plasma-enhanced chemical vapor deposition can form a substrate with a film of a uniform thickness when the film formation is carried out on a substrate having a large area, due to the distribution of voltage which is uniformly made over the entirety of the substrate.

Accordingly, an effect is obtained in which the yield in the production of substrates on which a substance is vapor deposited can be improved, and at the same time the quality of the produced substrates can be improved.

BRIEF DESCRIPTION OF DRAWINGS

Fig. 1 is a block diagram showing a main part of the apparatus for plasma-enhanced chemical vapor deposition according to the first embodiment.

Fig. 2 shows a stub provided to a coaxial cable of the apparatus for plasma-enhanced chemical vapor deposition according to the same embodiment.

Fig. 3 is a circuit diagram which is modeled after the stub shown in Fig. 2.

Fig. 4 shows characteristics of impedance Z corresponding to the length d of a branch cable for the stub in the apparatus for plasma-enhanced chemical vapor deposition according to the same embodiment.

Fig. 5 is a graph showing results of simulating a distribution of voltage on discharge electrodes corresponding to the length of the branch cables with the apparatus for plasma-enhanced chemical vapor deposition according to the same embodiment.

Fig. 6 is a graph showing results of simulating a distribution of voltage on discharge electrodes corresponding to the length of the branch cables with the apparatus for plasma-enhanced chemical vapor deposition according to the same embodiment.

Fig. 7 is a graph showing results of simulating a distribution of voltage on discharge electrodes corresponding to the length of the branch cables with the apparatus for plasma-enhanced chemical vapor deposition according to the same embodiment.

Fig. 8 shows a structure of a main part of the film formation chamber of the apparatus for plasma-enhanced chemical vapor deposition according to the second embodiment.

Fig. 9 is a graph showing results of simulating the speed of film formation on the substrate corresponding to the positions and a constant of terminal coils of the apparatus for plasma-enhanced chemical vapor deposition according to the same embodiment.

BEST MODE FOR CARRYING OUT THE INVENTION

Embodiments of the present invention are described below by referring to the drawings.

First Embodiment

First, an apparatus for plasma-enhanced chemical vapor deposition according to a first embodiment of the present invention will be described by referring to the drawings. Fig. 1 is a block diagram showing a structure of a main part of the apparatus for plasma-enhanced chemical vapor deposition according to this embodiment.

In Fig. 1, numeral 1 indicates a film formation chamber of the apparatus for plasma-enhanced chemical vapor deposition according to this embodiment. The film formation chamber 1 is provided inside with a ladder-shaped electrode 2 which is provided as discharge electrodes, a ground electrode (not shown) which is disposed opposite to the ladder-shaped electrode 2 at a predetermined distance and is grounded, and a substrate 3 which is held by the ground electrode.

In addition, the film formation chamber 1 is equipped with a gas supply pipe 4 for introducing a desired gas for forming a film to be vapor deposited on the substrate 3, containing a substance such as amorphous silicon and polycrystalline thin-film silicon, and with a gas exhaust pipe 5 for discharging the gas which has undergone decomposition in plasma. The film formation chamber 1 is structured such that the gas for forming a film is supplied from a gas supply source, which is not shown, via the gas supply pipe 4, and that the gas which has undergone decomposition in plasma is drawn out via the gas exhaust pipe 5 by a vacuum pump, which is not shown.

The ladder-shaped electrode 2 is assembled in the form of a lattice from a plurality of longitudinal electrode rods 2a which are in parallel and a pair of transverse electrode rods 2b and 2c which are disposed in parallel and opposite to each other. The ladder-shaped electrode 2 is disposed in parallel with and opposite to the substrate 3 which is held by a ground electrode (not shown). The transverse electrode rod 2b, which is a constituent of the ladder-shaped electrode 2, is provided, for example, with eight feeding points 6a to 6h. The transverse electrode rod 2c is also provided with eight feeding points 7a to 7h. The feeding points 6a to 6h and the feeding points 7a to 7h are positioned so as to divide the transverse electrode rods 2b and 2c, respectively, into divisions of an equal length so that the number of longitudinal electrode rods 2a which are assigned to each feeding point is the same.

When the substrate 3 is a rectangle with the dimensions 1100 mm by 1400 mm, the ladder-shaped electrode 2 which is measurably larger than the substrate 3, that is, a rectangle with the dimensions about 1200 m by 1500 m, is used.

Eight coaxial cables 8a to 8h are connected to the feeding points 6a to 6h, respectively, in order to feed to the ladder-shaped electrode 2 high-frequency electric power for generating plasma in which the gas for forming a film is decomposed. The other ends of the eight coaxial cables 8a to 8h opposite to the ends connected to the feeding points 6a to 6h are connected to output terminals of an electric power divider 10a which is disposed outside the film formation chamber 1.

The electric power divider 10a is a divider for distributing the high-frequency electric power which is output from the high-frequency electric power supply 11a to the feeding points 6a to 6h in equal amounts. An input terminal of the electric power divider 10a is connected to the high-frequency electric power supply 11a via a matching box 12a for adjusting impedance matching between the electric power divider 10a and the high-frequency electric power supply 11a so that the high-frequency electric power can be efficiently supplied.

In a manner similar to the above, eight coaxial cables 9a to 9h are connected to the feeding points 7a to 7h, respectively, in order to feed to the ladder-shaped electrode 2 high-frequency electric power for generating plasma in which the gas for forming a film is decomposed. The other ends of the eight coaxial cables 9a to 9h opposite to the ends connected to the feeding points 7a to 7h are connected to output terminals of an electric power divider 10b which is disposed outside the film formation chamber 1. An input terminal of the electric power divider 10b is connected to the high-frequency electric power supply 11b via a matching box 12b.

Similar to the electric power divider 10a, the electric power divider 10b is a divider for distributing the high-frequency electric power which is output from the high-frequency electric power supply 11b to the feeding points 7a to 7h in equal amounts. In a manner similar to the matching box 12a, the matching box 12b is used for adjusting impedance matching between the electric power divider 10b and the high-frequency electric power supply 11b so that the high-frequency electric power can be efficiently supplied.

The electric power dividers 10a and 10b, the high-frequency electric power supplies 11a and 11b, and the matching boxes 12a and 12b constitute a high-frequency electric power feeding circuit of the apparatus for plasma-enhanced chemical vapor deposition according to this embodiment.

According to such a structure, with the apparatus for plasma-enhanced chemical vapor deposition according to this embodiment, a gas for forming a film containing, for example, amorphous silicone is introduced through the gas supply pipe 4 into the film formation chamber 1 which has been evacuated into a vacuum, and at the same time, very-high-frequency (VHF) electric power having a frequency of, for example, 60.0 MHz is fed to the ladder-shaped electrode 2 from the high-frequency electric power supply 11a via the matching box 12a and the electric power divider 10a while the gas which has undergone decomposition in plasma is discharged through the gas exhaust pipe 5.

On the other hand, very-high-frequency (VHF) electric power having the same frequency as that of the high-frequency electric power supply 11a, i.e., 60.0 MHz, is fed to the ladder-shaped electrode 2 from the high-frequency electric power supply 11b via the matching box 12b and the electric power divider 10b. The phase of the high-frequency electric power supply 11b is varied over time with respect to the phase of the high-frequency electric power supply 11a so as to make uniform the distribution of voltage on the longitudinal electrode rods 2a between the feeding points 6a to 6h and the feeding points 7a to 7h. At the same time, the overall electric power supplied from the high-frequency electric power supply 11a and the high-frequency power supply 11b is adjusted, for example, to be 3000 W.

When plasma, in which the gas for forming a film containing amorphous silicon is decomposed, is generated between the ladder-shaped electrode 3 and the substrate 3 for 5 to 10 minutes in the above condition, a desired amorphous silicone is formed on the surface of the substrate 3. At this time, by varying the phase difference between the streams of high-frequency electric power, which have the same frequency, supplied from the high-frequency electric power supply 11a and the high-frequency electric power supply 11b over time, generation of standing waves on the discharge electrodes, which inhibits provision of uniformity in the film thickness, is avoided, and uniformity in the distribution of the film thickness in the direction of fed electric power can be promoted.

Next, a means for making the film thickness uniform in the direction at right angles with the direction of fed electric power when a substance is being vapor deposited on a substrate as above with an apparatus for plasma-enhanced chemical vapor deposition according to this embodiment will be described.

First, the coaxial cables 8a to 8h and the coaxial cables 9a to 9h will be further described. In the apparatus for plasma-enhanced chemical vapor deposition according to this embodiment, the coaxial cables 8a, 8b, 8g, 8h, 9a, 9b, 9g, and 9h are provided with impedance changers for adjusting impedance matching between each of these coaxial cables and each of corresponding feeding points 6a, 6b, 6g, 6h, 7a, 7b, 7g, and 7h.

Specific explanation will be given by referring to the drawings. Fig. 2 is a detailed view of the coaxial cable 8h, which typifies the coaxial cables 8a, 8b, 8g, 8h, 9a, 9b, 9g, and 9h. The coaxial cable 8h is provided outside (the atmosphere side) the film formation chamber 1 with a T-shaped connector 21 from which the coaxial cable 8h branches out and with a branch cable 22 which is connected to a branch terminal of the T-shaped connector 21.

The branch cable 22 which branches off from the coaxial cable 8h by the T-shaped connector 21 constitutes a stub for the coaxial cable 8h. The impedance at the feeding point 6h toward the electric power divider 10a (i.e., toward the high-frequency electric power feeding circuit) can be changed by adjusting the impedance of the stub.

This can be explained as follows using a model stub shown in Fig. 3. When the characteristic impedance of the branch cable 22 used as the stub is the same as the characteristic impedance $Z_O$ of the coaxial cable 8h (50 ohms, for example), the length of the branch cable 22 is d, and the impedance of the load connected to the distal end (opposite to the branch terminal of the T-shaped connector) of the stub (branch cable 22) is $Z_R$, the impedance Z at the branch terminal of the T-shaped connector 21 toward the distal end of the stub (branch cable 22) can be obtained by the following formula (1).

$$\dot{Z} = \dot{Z}_O \cdot \frac{\dot{Z}_R + j\dot{Z}_O \tan(\beta d)}{\dot{Z}_O + j\dot{Z}_R \tan(\beta d)} \qquad (1)$$

wherein $\beta = 2\pi/\lambda$

In Fig. 2, Fig. 3, and formula (1), a dot given on top of a character of an element (character representing an impedance) indicates that the element is expressed as a complex number including a resistance component and an inductance component. All impedances which are dealt with in this embodiment and the following second embodiment are regarded as being expressed as complex numbers.

Accordingly, as is clear from comparison between the characteristics of impedance Z dependent on the length d of the branch cable 22 when the distal end of the stub (branch cable 22) is short-circuited (short circuit: impedance $Z_R$ = 0) as shown in Fig. 4A and the characteristics of impedance Z dependent on the length d of the branch cable 22 when the distal end of the stub (branch cable 22) is open-circuited (open circuit: impedance $Z_R$ = infinite) as shown in Fig. 4B, the impedance Z at the branch terminal of the T-shaped connector 21 toward the distal end of the stub (branch cable 22) can be changed by simply short-circuiting or open-circuiting the distal end of the stub (branch cable 22) even if the length d of the branch cable 22 is constant.

As shown in Figs. 4A and 4B, in the short circuit and the open circuit, the impedance Z is 0 at the nodes of voltage standing waves (points where d = 0, λ/2, λ ... with the short circuit; or points where d = λ/4, 3λ/4, 5λ/4 ... with the open circuit) since the voltage there is 0, and the impedance Z is infinite at the antinodes of voltage standing waves (points where d = λ/4, 3λ/4, 5λ/4 ... with the short circuit; or points where d = 0, λ/2, λ ... with the open circuit) since the electric current there is 0.

Therefore, the impedance at the feeding point 6h toward the electric power divider 10a (toward the high-frequency electric power feeding circuit), which is a complex impedance combining the impedance Z of the stub and the impedance at the input terminal of the T-shaped connector 21 toward the electric power divider 10a (toward the high-frequency electric power feeding circuit), can be changed by short-circuiting or open-circuiting the distal end of the stub (branch cable 22).

Even when the stub (branch cable 22) is kept short-circuited or open-circuited at the distal end, the impedance Z at the branch terminal of the T-shaped connector 21 toward the distal end of the stub (branch cable 22) can be changed by changing the length d of the branch cable 22. Accordingly, the impedance at the feeding point 6h toward the electric power divider 10a (toward the high-frequency electric power feeding circuit) can also be changed in a similar manner according to the length d of the branch cable 22.

In addition, a load using a passive element such as a coil, a capacitor, or a resistor, or using a complex circuit combining these may be connected to the distal end of the stub (branch cable 22) so that the impedance Z at the branch terminal of the T-shaped connector 21 toward the distal end of the stub (branch cable 22) can be changed by changing the impedance ZR of the load with change in a constant of the passive element.

Alternatively, the impedance Z at the branch terminal of the T-shaped connector 21 toward the distal end of the stub (branch cable 22) can also be changed by differentiating the characteristic impedance of the branch cable 22 itself for use as the stub from the characteristic impedance of the coaxial cable 8h. Accordingly, the impedance at the feeding point 6h toward the electric power divider 10a (toward the high-frequency electric power feeding circuit) can also be changed in a similar manner according to the characteristic impedance of the branch cable 22.

The coaxial cables other than the coaxial cable 8h, i.e., coaxial cables 8a, 8b, 8g, 9a, 9b, 9g, and 9h, are also provided with similar T-shaped connectors 21 and branch cables 22.

Accordingly, with an apparatus for plasma-enhanced chemical vapor deposition according to this embodiment, the stubs provided to the coaxial cables 8a, 8b, 8g, 8h, 9a, 9b, 9g, and 9h are used to adjust impedance matching between the coaxial cables 8a, 8b, 8g, 8h, 9a, 9b, 9g, and 9h and corresponding feeding points 6a, 6b, 6g, 6h, 7a, 7b, 7g, and 7h, whereby high-frequency electric power which is fed to the feeding points 6a, 6b, 6g, 6h, 7a, 7b, 7g, and 7h, that is, to the plurality of longitudinal electrode rods 2a in parallel which constitute the ladder-shaped electrode 2, can be adjusted, and thus the distribution of voltage at the right or left part (which is a substrate end part at an end in a direction at right angles to the direction of fed electric power) of the substrate and the distribution of voltage at the central part of the substrate can be balanced.

Therefore, the distribution of voltage which is applied between the ladder-shaped electrode 2 and the substrate 3 in order to generate plasma can be made uniform over the entirety of the substrate, and a film having a uniform thickness can be formed on the substrate due to the distribution of voltage which is uniformly made.

Fig. 5 is a graph showing, as an example, results of simulating a distribution of voltage occurring in a direction at right angles to a direction of fed electric power through the discharge electrodes, as along central part S of the discharge electrodes shown in Fig. 1, when the coaxial cables 8a, 8h, 9a, and 9h are provided with the stubs, which are the branch cables 22 with their distal ends open-circuited, and when the length d of the branch cables 22 is varied. As is seen in Fig. 5, the distribution of voltage at a distance from about 100 mm to about 300 mm and from about 1300 mm to about 1500 mm from one end of the substrate 3, corresponding to the feeding points 6a, 6h, 7a, and 7h, to which the coaxial cables 8a, 8h, 9a, and 9h are connected, can be effectively adjusted according to the length d of the branch cables 22.

Fig. 6 is a graph showing, as an example, results of simulating a distribution of voltage occurring in a direction at right angles to a direction of fed electric power through the discharge electrodes, as along central part S of the discharge electrodes shown in Fig. 1, when the coaxial cables 8b, 8g, 9b, and 9g are provided with the stubs, which are the branch cables 22 with their distal ends open-circuited, and when the length d of the branch cables 22 is varied. As is seen in Fig. 6, the distribution of voltage at a distance from about 200 mm to about 400 mm and from about 1200 mm to about 1400 mm from one end of the substrate 3, corresponding to the feeding points 6b, 6g, 7b, and 7g, to which the coaxial cables 8b, 8g, 9b, and 9g are connected, can be effectively adjusted according to the length d of the branch cables 22.

Fig. 7 is a graph showing, as an example, results of simulating a distribution of voltage occurring in a direction at right angles to a direction of fed electric power through the discharge electrodes, as along central part S of the discharge electrodes shown in Fig. 1, when the coaxial cables 8a, 8b, 8g, 8h, 9a, 9b, 9g, and 9h are provided with the stubs, which are the branch cables 22 with their distal ends open-circuited, and when the length d of the branch cables 22 is varied. In this example, effects as shown in Fig. 5 and Fig. 6 are combined, and as is seen in Fig. 7, the distribution of voltage at a distance from about 100 mm to about 400 mm and from about 1200 mm to about 1500 mm from one end of the substrate 3, corresponding to the feeding points 6a, 6b, 6g, 6h, 7a, 7b, 7g, and 7h, to which the coaxial cables 8a, 8b, 8g, 8h, 9a, 9b, 9g, and 9h are connected, can be more effectively adjusted according to the length d of the branch cables 22.

Conditions for calculating the simulations shown in Figs. 5, 6, and 7 are: (1) electron mass: 9.11E-31 kg; (2) frequency of the high-frequency electric power: 60 MHz; (3) pressure of the gas: 6.66 Pa; electron temperature: 3.0 eV; (5) distance between the electrode and the counter electrode: 38 mm; (6) electron mass: 1.62E-19 C; (7) radius of the ladder-shaped conductor: 5 mm; (8) electron density: 5.0E-8 $cc^{-1}$; (9) dielectric constant: 8.854E-12 F/m; sheath length/device length: 2. In Figs. 5 and 6, "len" indicates the numerical value of the length d of the branch cables 22 obtained by substituting the actual wavelength X of the high-frequency electric power for the wavelength $\lambda$ in the expression of the length d.

As a result of determining conditions of the stubs by referring to Figs. 5, 6, and 7, optimal conditions were obtained with the apparatus for plasma-enhanced chemical vapor deposition according to this embodiment when the length d of the branch cables 22 provided to the coaxial cables 8a, 8h, 9a, and 9h met the equation $d = \lambda/2.222$, and the branch cables 22 provided to the coaxial cables 8b, 8g, 9b, and 9g met the equation $d = \lambda/2.083$, in the case where the coaxial cables 8a, 8b, 8g, 8h, 9a, 9b, 9g, and 9h were provided with stubs which were the branch cables 22 with their distal ends open-circuited. Specifically, the error in the thickness of the film over the entirety of the substrate 3 can be reduced to within about $\pm 10\%$ of the thickness of the film, in addition to the effect of sufficiently controlling generation of standing waves on the ladder-shaped electrode 2, which inhibits provision of uniformity in the film thickness, by varying the phase difference between the streams of high-frequency electric power, which have the same frequency, supplied from the high-frequency electric power supply 11a and the high-frequency electric power supply 11b over time.

In the above-described embodiment, the cases are described where the stubs are provided to the coaxial cables 8a, 8b, 8g, 8h, 9a, 9b, 9g, and 9h out of the coaxial cables 8a to 8h and 9a to 9h; however, the position and the number of the coaxial cables which are provided with the stubs are not limited to the 8 stubs as above, and the stubs may be provided to any of the coaxial cables, including additional coaxial cables to the above coaxial cables. Accordingly, it is believed that the number of combinations of the stubs provided to n number of coaxial cables (wherein n is a positive integer) is a sum of the numbers of the combinations when the number of the coaxial cables which are selected is 1, 2, 3, ..., and n.

The device for changing impedance at the feeding points toward the electric power divider (high-frequency electric power feeding circuit) is not limited to stubs as described above, but any device can be used as long as it can adjust impedance matching between the individual coaxial cables and corresponding feeding points.

As described above, with the apparatus for plasma-enhanced chemical vapor deposition according to the first embodiment, when a desired substance is vapor deposited on the surface of the substrate 3, the stubs provided to the plurality of coaxial cables for supplying high-frequency electric power from the high-frequency electric power supply circuit to the ladder-shaped electrode 2, so as to make the film thickness uniform in the direction at right angles with the direction of fed electric power, adjust impedance matching between each coaxial cable and the corresponding feeding point for the ladder-shaped electrode 2, whereby high-frequency electric power which is fed to each longitudinal electrode rod 2a of the ladder-shaped electrode 2 can be adjusted, and the distribution of voltage at a right or left part of the substrate and the distribution of voltage at a central part of the substrate can be balanced, as well as avoiding generation of standing waves on the ladder-shaped electrode 2, which inhibits provision of uniformity in the film thickness, and promoting uniformity in the distribution of the film thickness in the direction of fed electric power, by supplying streams of high-frequency electric power having the same frequency from the high-frequency electric power supplies 11a and 11b to the ladder-shaped electrode 2, and by varying the phase difference between the streams of high-frequency electric power, which have the same frequency, supplied from the high-frequency electric power supplies 11a and 11b over time.

Accordingly, an effect is obtained in which characteristics of the distribution of the thickness of a film on a substrate having a large area are improved, whereby the yield in the production of substrates on which a substance is vapor deposited can be improved, and at the same time the quality of the produced substrates can be improved.

In particular, when a film is formed on a substrate having a PiN structure for use in an amorphous silicon solar cell or the like, for example, a p-type layer, an i-type layer, and an n-type layer are all effectively formed, and cell properties can be greatly improved. Since the distribution of the film thickness is made uniform, additional effects are obtained in which cutting performance of laser in a laser etching step in a process can be greatly improved, and the appearance of the product is improved. Moreover, since the deposition of the substance on the inside of the film formation chamber is also made uniform, effects are also obtained in which cleaning time for self-cleaning can be shortened, and influence on film formation before or after cleaning can be minimized.

Second Embodiment

Next, an apparatus for plasma-enhanced chemical vapor deposition according to a second embodiment of the present invention will be described by referring to the drawings. The case will be described in which, in the apparatus for enhanced chemical vapor deposition according to the second embodiment, impedance matching between each coaxial cable and the corresponding feeding point for the ladder-shaped electrode 2 is adjusted by changing the impedance toward the ladder-shaped electrode 2 without providing coaxial cables with stubs, as opposed to the apparatus for plasma-enhanced chemical vapor deposition according to the first embodiment in which the stubs provided to the plurality of coaxial cables for supplying high-frequency electric power from the high-frequency electric power supply circuit to the ladder-shaped electrode 2 adjust impedance matching between each coaxial cable and the corresponding feeding point for the ladder-shaped electrode 2, whereby high-frequency electric power which is fed to each longitudinal electrode rod 2a of the ladder-shaped electrode 2 can be adjusted.

Accordingly, only the interior structure of the film formation chamber 1 of the apparatus for plasma-enhanced chemical vapor deposition will be described in the following description, and description of other structures will be omitted since they are the same as those of the apparatus for plasma-enhanced chemical vapor deposition according to the first example described using Fig. 1, except that the coaxial cables are not provided with stubs as explained above. Fig. 8 shows a structure of a main part of the film formation chamber 1 of the apparatus for plasma-enhanced chemical vapor deposition according to this embodiment.

In Fig. 8, terminal coils 31a and 31b are coils connected between a transversal electrode rod 2b, which is a constituent of a ladder-shaped electrode 2, and a grounding point (for example, a ground electrode, which is not shown) in the vicinity of a right or left part (which is a substrate end part at an end in a direction at right angles to the direction of fed electric power) of a substrate 3, mainly so as to change the impedance at 8 feeding points 6a to 6h of the apparatus for plasma-enhanced chemical vapor deposition according to this embodiment toward the ladder-shaped electrode 2. The complex impedance combining the impedances of the coils and the impedance of the ladder-shaped electrode 2 equals the impedance at the feeding points 6a to 6h toward the ladder-shaped electrode 2.

Similarly, in Fig. 8, terminal coils 31c and 31d are coils connected between a transversal electrode rod 2c, which is a constituent of the ladder-shaped electrode 2, and a grounding point (for example, a ground electrode, which is not shown) in the vicinity of a right or left part (which is a substrate end part at an end in a direction at right angles to the direction of fed electric power) of the substrate 3, mainly so as to change the impedance at 8 feeding points 7a to 7h of the apparatus for plasma-enhanced chemical vapor deposition according to this embodiment toward the ladder-shaped electrode 2. The complex impedance combining the impedances of the coils and the impedance of the ladder-shaped electrode 2 equals the impedance at the feeding points 7a to 7h toward the ladder-shaped electrode 2.

Accordingly, with an apparatus for plasma-enhanced chemical vapor deposition according to this embodiment, impedance matching between the coaxial cables 8a to 8h and 9a to 9h and the corresponding feeding points 6a to 6h and 7a to 7h is adjusted with change in a constant of the terminal coils 31a to 31d, whereby high-frequency electric power which is fed to a plurality of longitudinal electrode rods 2a in parallel which constitute the ladder-shaped electrode 2 can be adjusted, and thus the distribution of voltage at the right or left part of the substrate and the distribution of voltage at the central part of the substrate can be balanced.

Fig. 9 shows results of simulating the relationship between the positions where the terminal coils 31a to 31d (shown as symbols which schematically illustrate coils in Fig. 9) are connected and the relative speed of film formation depending on the adjusted distribution of voltage along the central part of the discharge electrodes (central position S of the discharge electrodes shown in Fig. 8) using constant L of the terminal coils 31a to 31d as a parameter. As is seen in Fig. 9, the speed of film formation on the substrate 3 depending on the adjusted distribution of voltage on the ladder-shaped electrode 2 can be effectively adjusted according to the constant of the terminal coils 31a to 31d.

Accordingly, using the terminal coils 31a to 31d, the distribution of voltage which is applied between the ladder-shaped electrode 2 and the substrate 3 in order to generate plasma can be made uniform over the entirety of the substrate, and a film having a uniform thickness can be formed on the substrate due to the distribution of voltage which is uniformly made.

Although the terminal coils 31a to 31d connected between the ladder-shaped electrode 2 and the grounding points are used in order to change the impedance at the feeding points toward the ladder-shaped electrode 2 in the above embodiment, modification may be made by connecting a passive element such as a capacitor or resistor, or connecting a complex circuit combining these and coils instead of connecting the terminal coils 31a to 31d, so that the impedance at the feeding points toward the ladder-shaped electrode 2 can be changed with change in the constant L of the passive element. Moreover, the number of the terminal coils, passive elements such as capacitors or resistors, or complex circuits combining these and coils is not limited to four as described above, but may be any number.

The device for changing impedance at the feeding points toward the ladder-shaped electrode is not limited to the passive elements or their complex circuits as described above, but any device can be used as long as it can adjust impedance matching between the individual coaxial cables and corresponding feeding points.

As described above, with the apparatus for plasma-enhanced chemical vapor deposition according to the second embodiment, when a desired substance is vapor deposited on the surface of the substrate 3, the terminal coils 31a to 31d connected to the ladder-shaped electrode 2, so as to make the film thickness uniform in the direction at right angles with the direction of fed electric power, adjust the impedance matching between each coaxial cable and the corresponding feeding point for the ladder-shaped electrode 2, whereby high-frequency electric power which is fed to each longitudinal electrode rod 2a of the ladder-shaped electrode 2 can be adjusted, and the distribution of voltage at a right or left part of the substrate and the distribution of voltage at a central part of the substrate can be balanced, as well as avoiding generation of standing waves on the ladder-shaped electrode 2, which inhibits provision of uniformity in the film thickness, and promoting uniformity in the distribution of the film thickness in the direction of fed electric power, by supplying streams of high-frequency electric power having the same frequency from the high-frequency electric power supplies 11a and 11b to the ladder-shaped electrode 2, and by varying the phase difference between the streams of high-frequency electric power, which have the same frequency, supplied from the high-frequency electric power supplies 11a and 11b over time.

Accordingly, in a manner similar to that of the first embodiment, an effect is obtained in which characteristics of the distribution of the thickness of a film on a substrate having a large area are improved, whereby the yield in the production of substrates on which a substance is vapor deposited can be improved, and at the same time the quality of the produced substrates can be improved.

It should be noted that although cases are described in the above-described first and second embodiment in which the impedance adjustment using stubs (impedance adjusters) which are provided to the coaxial cables and the impedance adjustment using terminal coils (impedance adjusters) which are connected to the ladder-shaped electrode 2 are separately carried out, these impedance adjustments may be carried out at the same time. By doing so, even finer adjustment of the distribution of voltage is possible.

Moreover, although cases are described in the above-described first and second embodiment in which vapor deposition of a substance on a substrate is carried out by generating plasma, a process of etching a substance on a substrate using plasma may also be carried out while adjusting the high-frequency electric power fed to the ladder-shaped electrode 2.

## Claims

1. An apparatus for plasma processing with which high-frequency electric power generated by a high-frequency electric power feeding circuit is fed to a plurality of discharge electrodes, and plasma is generated between the discharge electrodes and a substrate which are in a processing chamber into which a gas for processing has been introduced, so as to process a substance on the substrate,

   the apparatus for plasma processing comprising:

   a voltage distribution regulator for adjusting deviation in distribution of voltage on the discharge electrodes, the distribution of voltage occurring in a direction at right angles to a direction of fed electric power through the discharge electrodes.

2. An apparatus for plasma-enhanced chemical vapor deposition with which high-frequency electric power generated by a high-frequency electric power feeding circuit is fed to a plurality of discharge electrodes, and plasma is generated between the discharge electrodes and a substrate which are in a film formation chamber into which a gas for forming a film containing a substance has been introduced, so as to vapor deposit the substance on the substrate,

   the apparatus for plasma-enhanced chemical vapor deposition comprising:

   a voltage distribution regulator for adjusting deviation in distribution of voltage on the discharge electrodes, the distribution of voltage occurring in a direction at right angles to a direction of fed electric power through the discharge electrodes.

3. An apparatus for plasma-enhanced chemical vapor deposition according to claim 2, wherein the voltage distribution regulator is an impedance changer which is provided to at least one of a plurality of high-frequency cables for supplying high-frequency electric power from the high-frequency electric power feeding circuit to the plurality of discharge electrodes in order to change an impedance at a feeding point for the discharge electrodes toward the high-frequency electric power feeding circuit.

4. An apparatus for plasma-enhanced chemical vapor deposition according to claim 3, wherein the impedance changer is a stub comprising a branch cable which branches off from the high-frequency cable.

**5.** An apparatus for plasma-enhanced chemical vapor deposition according to claim 4, wherein the stub comprises a passive element which is connected to a distal end of the branch cable, and, with s change in a constant of the passive element, the stub changes the impedance at a feeding point for the discharge electrodes toward the high-frequency electric power feeding circuit.

**6.** An apparatus for plasma-enhanced chemical vapor deposition according to claim 4, wherein, with change in the cable length of the branch cable, the stub changes the impedance at a feeding point for the discharge electrodes toward the high-frequency electric power feeding circuit.

**7.** An apparatus for plasma-enhanced chemical vapor deposition according to claim 4, wherein, with change in the characteristic impedance of the branch cable itself, the stub changes the impedance at a feeding point for the discharge electrodes toward the high-frequency electric power feeding circuit.

**8.** An apparatus for plasma-enhanced chemical vapor deposition according to claim 2, wherein the voltage distribution regulator is an impedance changer which is provided between the discharge electrodes and a grounding point in order to change the impedance at a feeding point for the discharge electrodes toward the discharge electrodes.

**9.** An apparatus for plasma-enhanced chemical vapor deposition according to claim 8, wherein the impedance changer comprises a passive element which is connected between the discharge electrodes and the grounding point, and, with change in a constant of the passive element, the impedance changer changes the impedance between the discharge electrodes and the grounding point.

**10.** A method of processing a substrate with an apparatus for plasma processing by feeding high-frequency electric power generated by a high-frequency electric power feeding circuit to a plurality of discharge electrodes, and generating plasma between the discharge electrodes and a substrate in a processing chamber into which a gas for processing has been introduced, so as to process a substance on the substrate,

the method of processing a substrate with an apparatus for plasma processing comprising:

adjusting deviation in distribution of voltage on the discharge electrodes, the distribution of voltage occurring in a direction at right angles to a direction of fed electric power through the discharge electrodes, whereby distribution of voltage at an end part of the substrate, the end part being at an end in the direction at right angles to the direction of fed electric power, and distribution of voltage at a central part of the substrate are balanced, so that distribution of voltage which is applied between the discharge electrodes and the substrate in order to generate plasma is made uniform over the entirety of the substrate.

**11.** A method for film formation with an apparatus for plasma-enhanced chemical vapor deposition by feeding high-frequency electric power generated by a high-frequency electric power feeding circuit to a plurality of discharge electrodes, and generating plasma between the discharge electrodes and a substrate in a film formation chamber into which a gas for forming a film has been introduced, so as to vapor deposit the substance on the substrate,

the method for film formation with an apparatus for plasma-enhanced chemical vapor deposition comprising:

adjusting deviation in distribution of voltage on the discharge electrodes, the distribution of voltage occurring in a direction at right angles to a direction of fed electric power through the discharge electrodes, whereby distribution of voltage at an end part of the substrate, the end part being at an end in the direction at right angles to the direction of fed electric power, and distribution of voltage at a central part of the substrate are balanced, so that distribution of voltage which is applied between the discharge electrodes and the substrate in order to generate plasma is made uniform over the entirety of the substrate.

FIG. 1

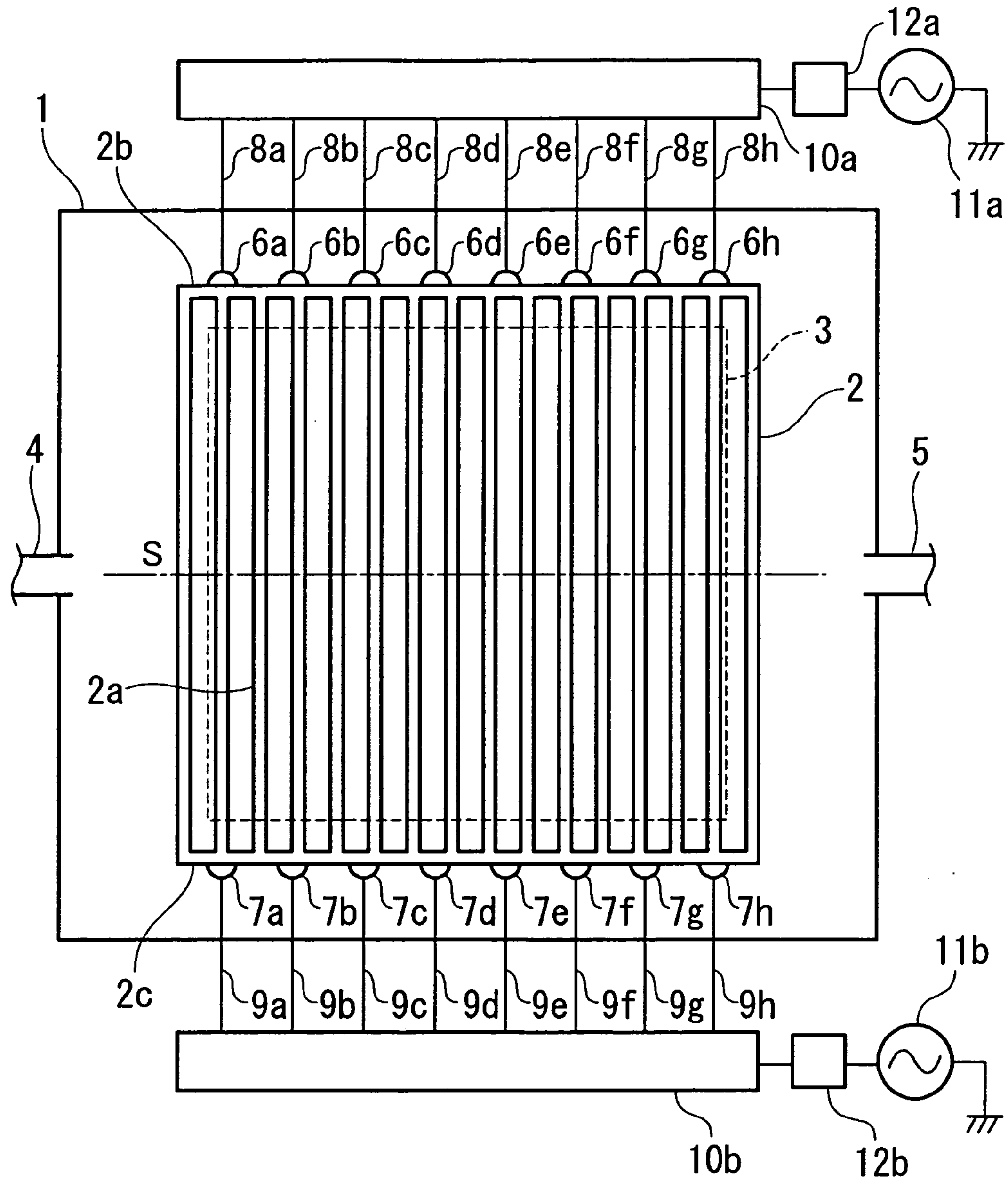
12a
1
2b
8a
8b
8c
8d
8e
8f
8g
8h
10a
11a
6a
6b
6c
6d
6e
6f
6g
6h
3
2
4
5
S
2a
7a
7b
7c
7d
7e
7f
7g
7h
11b
2c
9a
9b
9c
9d
9e
9f
9g
9h
10b
12b

FIG. 2

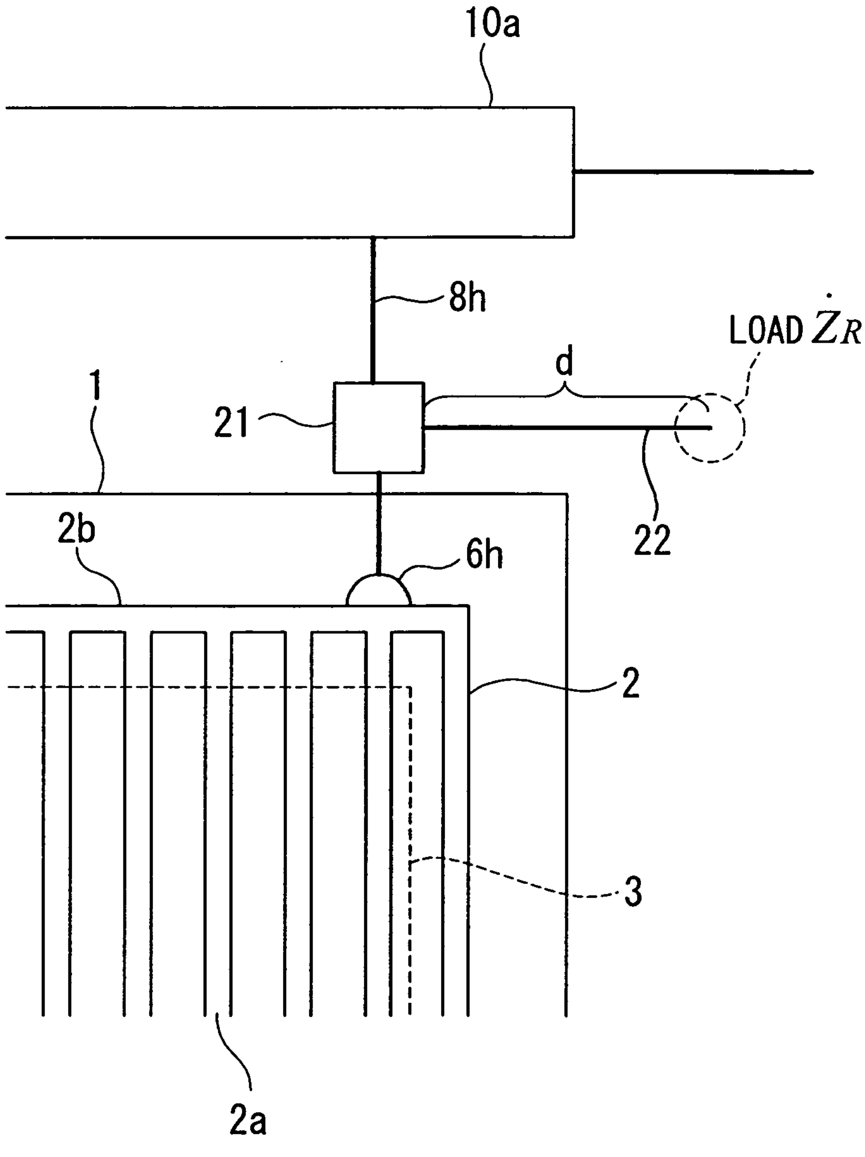

FIG. 3

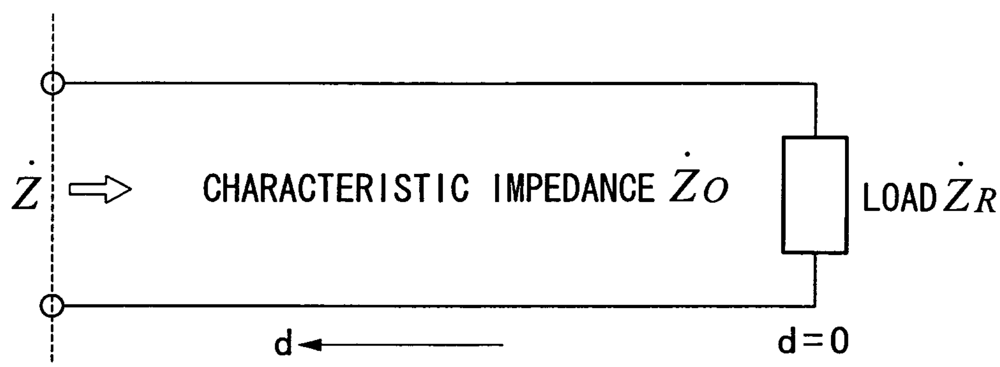

FIG. 4A

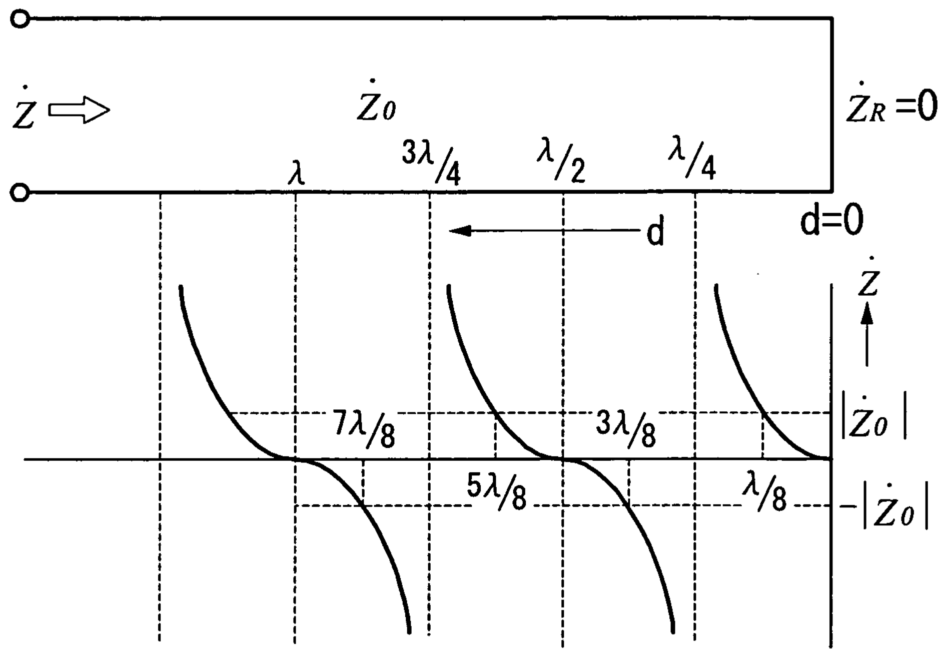
Ż
Ż0
ŻR =0
λ
3λ/4
λ/2
λ/4
d
d=0
Ż
7λ/8
3λ/8
|Ż0|
5λ/8
λ/8
-|Ż0|

FIG. 4B

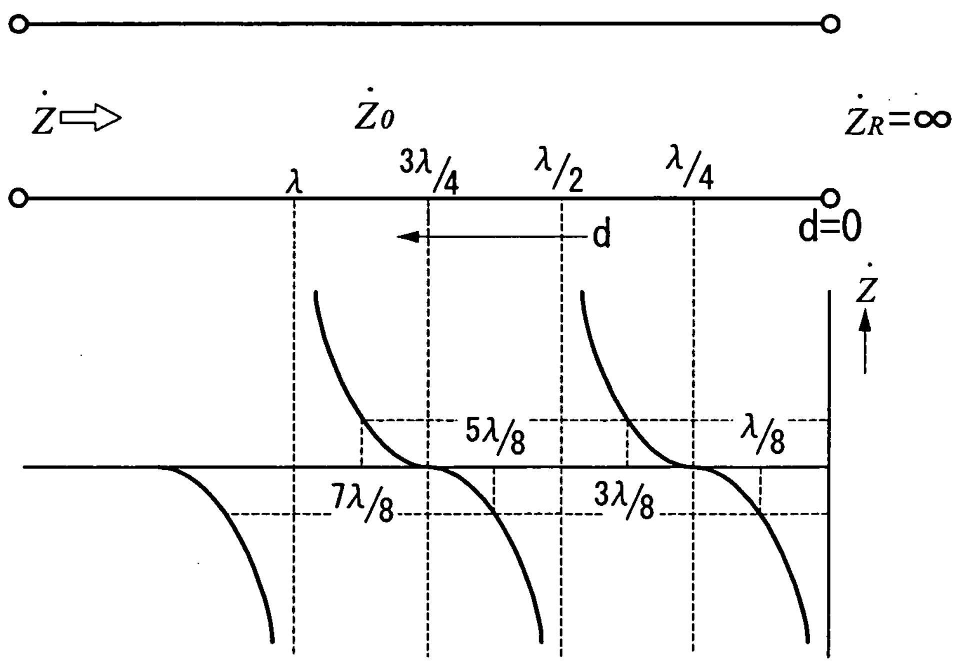
Ż
Ż0
ŻR=∞
λ
3λ/4
λ/2
λ/4
d
d=0
Ż
5λ/8
λ/8
7λ/8
3λ/8

FIG. 5

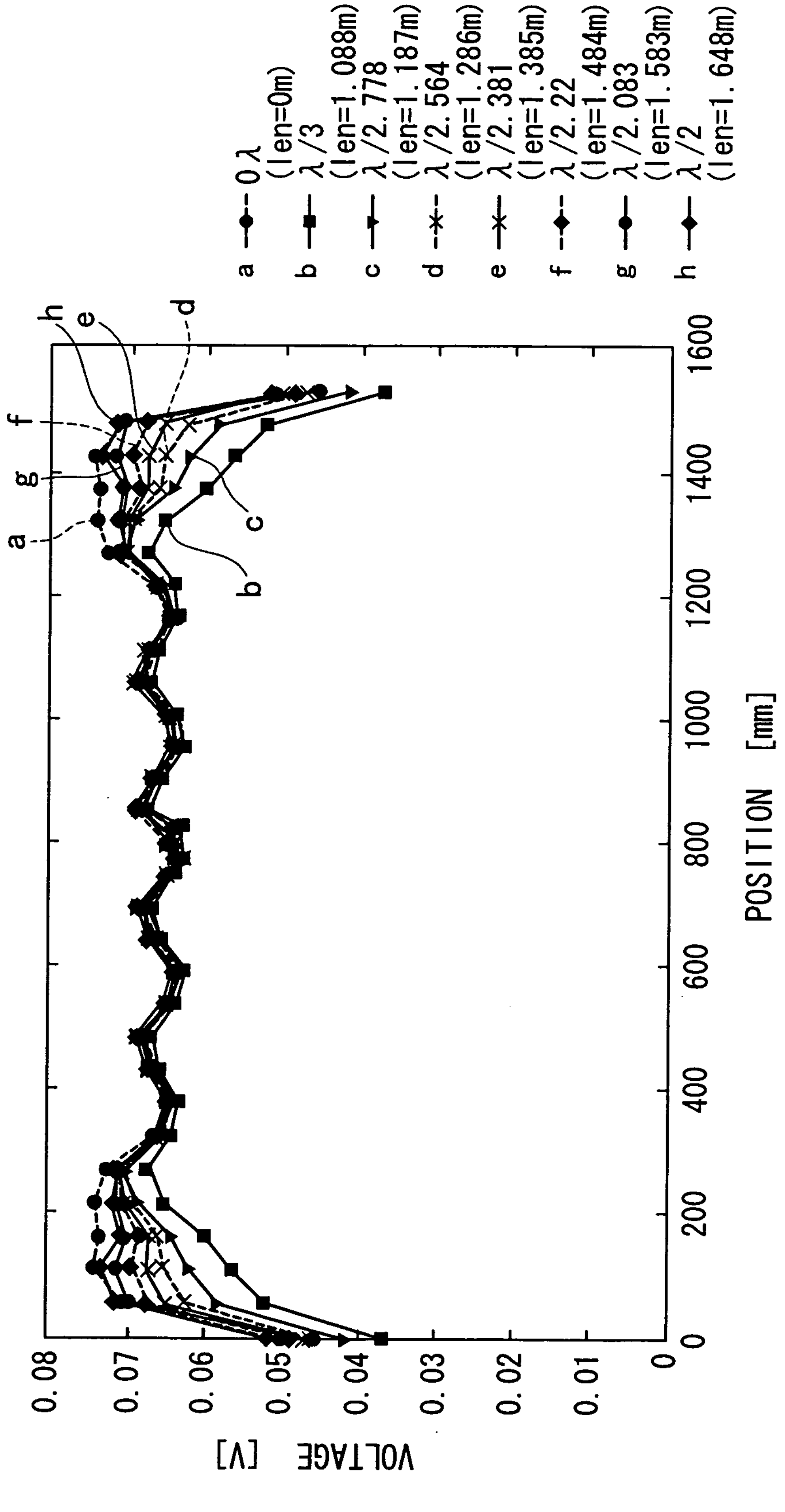
VOLTAGE [V]
0.08
0.07
0.06
0.05
0.04
0.03
0.02
0.01
0
0
200
400
600
800
1000
1200
1400
1600
POSITION [mm]
a
b
c
d
e
f
g
h
a 0λ (len=0m)
b λ/3 (len=1.088m)
c λ/2.778 (len=1.187m)
d λ/2.564 (len=1.286m)
e λ/2.381 (len=1.385m)
f λ/2.22 (len=1.484m)
g λ/2.083 (len=1.583m)
h λ/2 (len=1.648m)

FIG. 6

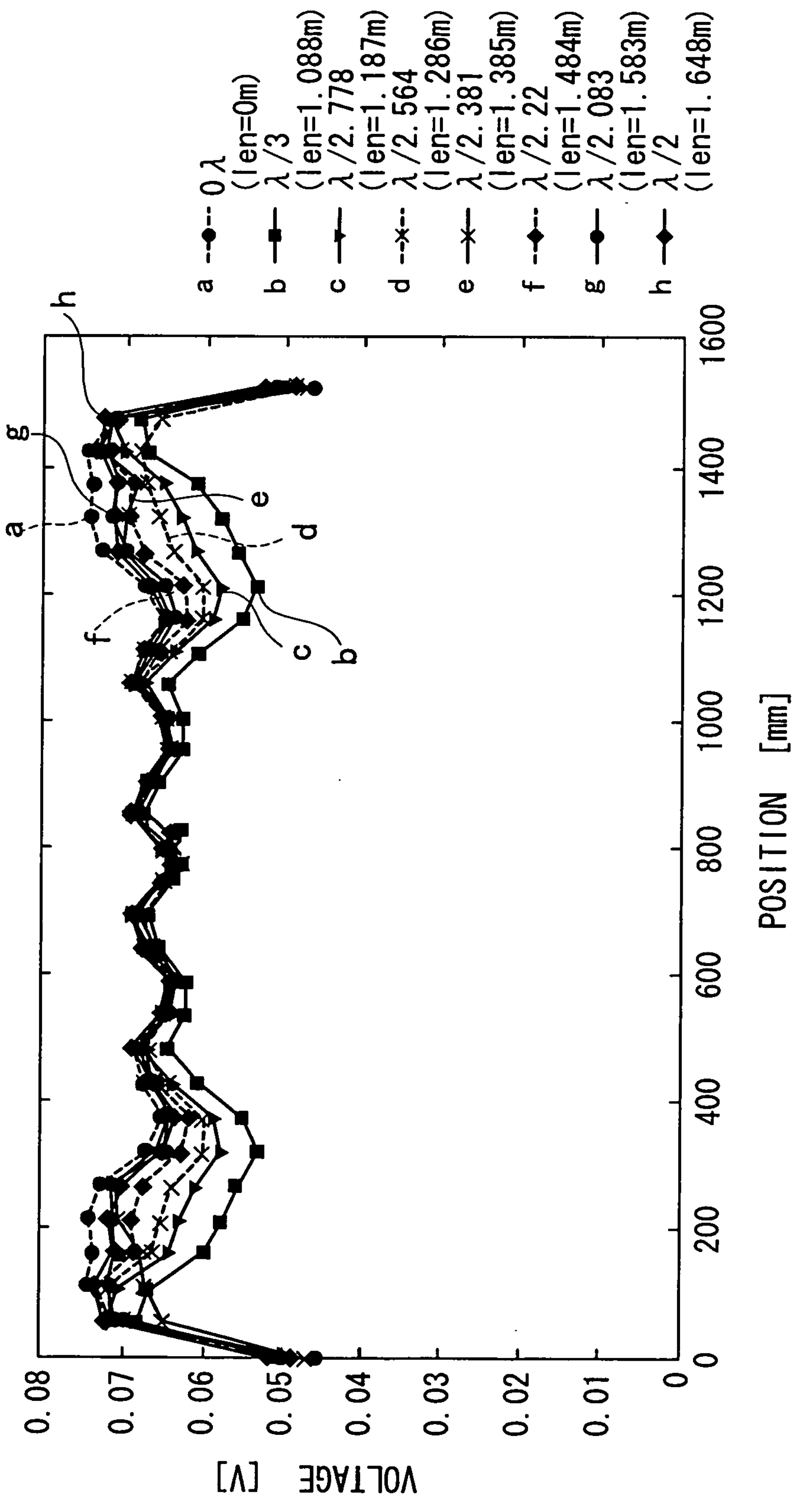
VOLTAGE [V]
POSITION [mm]
0.08
0.07
0.06
0.05
0.04
0.03
0.02
0.01
0
200
400
600
800
1000
1200
1400
1600
a --●-- 0λ (len=0m)
b —■— λ/3 (len=1.088m)
c —▼— λ/2.778 (len=1.187m)
d --×-- λ/2.564 (len=1.286m)
e —×— λ/2.381 (len=1.385m)
f --◆-- λ/2.22 (len=1.484m)
g —●— λ/2.083 (len=1.583m)
h —◆— λ/2 (len=1.648m)

FIG. 7

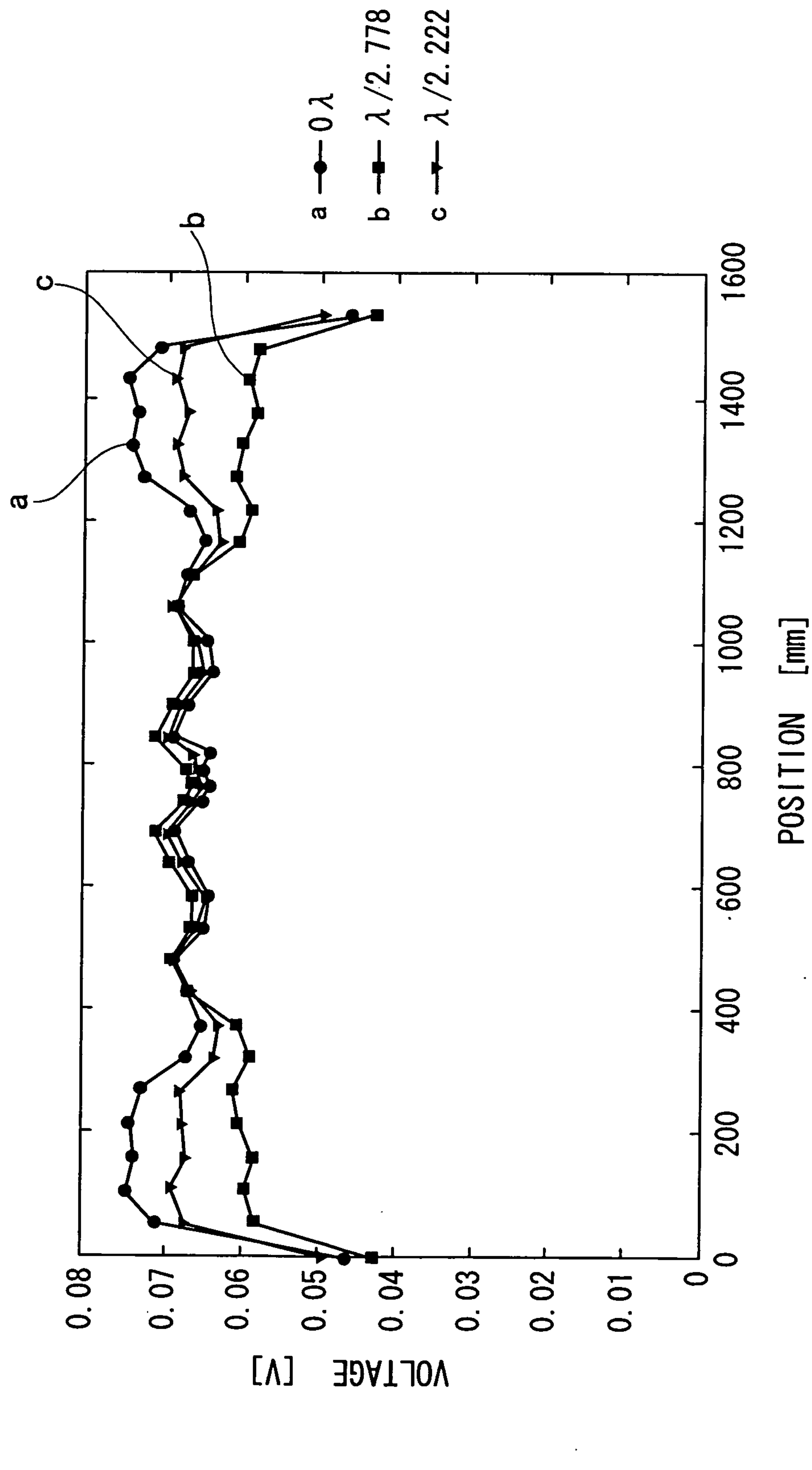
VOLTAGE [V]
0.08
0.07
0.06
0.05
0.04
0.03
0.02
0.01
0
POSITION [mm]
0
200
400
600
800
1000
1200
1400
1600
a
b
c
a —●— 0λ
b —■— λ/2. 778
c —▼— λ/2. 222

FIG. 8

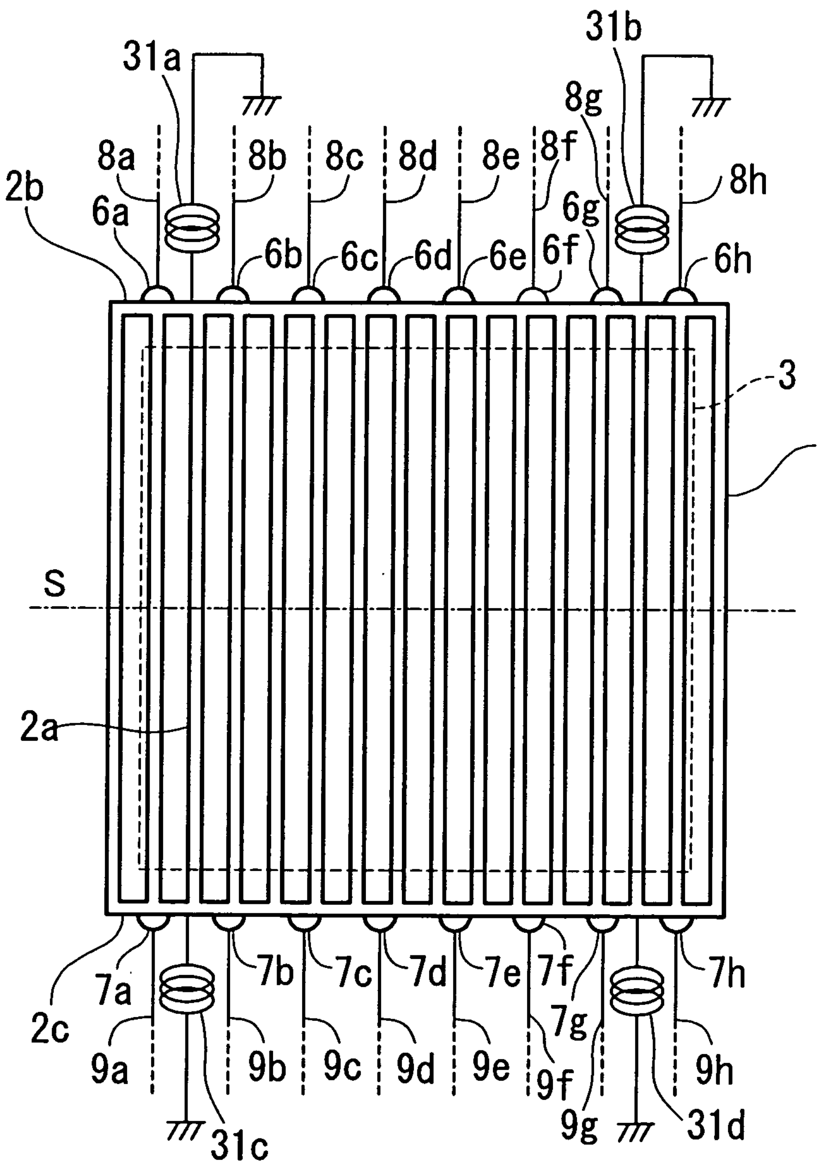
31a
31b
8a
8b
8c
8d
8e
8f
8g
8h
2b
6a
6b
6c
6d
6e
6f
6g
6h
3
2
S
2a
2c
7a
7b
7c
7d
7e
7f
7g
7h
9a
9b
9c
9d
9e
9f
9g
9h
31c
31d

FIG. 9

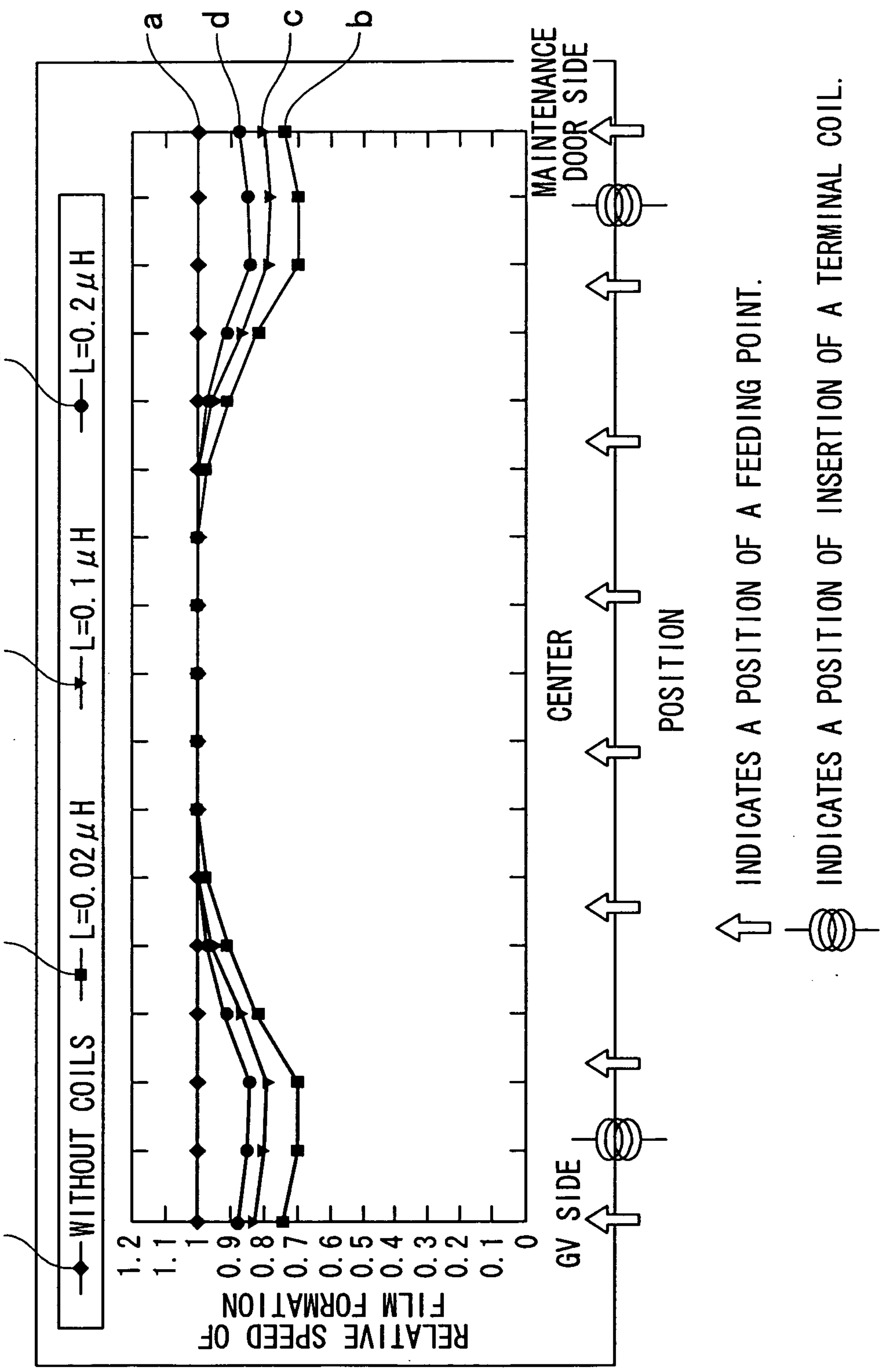

a
b
c
d
WITHOUT COILS
L=0.02 μH
L=0.1 μH
L=0.2 μH
RELATIVE SPEED OF FILM FORMATION
1.2
1.1
1
0.9
0.8
0.7
0.6
0.5
0.4
0.3
0.2
0.1
0
GV SIDE
CENTER
MAINTENANCE DOOR SIDE
POSITION
INDICATES A POSITION OF A FEEDING POINT.
INDICATES A POSITION OF INSERTION OF A TERMINAL COIL.

## INTERNATIONAL SEARCH REPORT

International application No.
PCT/JP03/12563

A. CLASSIFICATION OF SUBJECT MATTER
Int.Cl[7] C23C16/509, H01L21/205, H05H1/46, B01J19/08

According to International Patent Classification (IPC) or to both national classification and IPC

B. FIELDS SEARCHED

Minimum documentation searched (classification system followed by classification symbols)
Int.Cl[7] C23C16/50-16/517, H01L21/205, H05H1/46

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2003 |
| Kokai Jitsuyo Shinan Koho | 1971-2003 | Toroku Jitsuyo Shinan Koho | 1994-2003 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | EP 0955665 A2 (MITSUBISHI HEAVY INDUSTRIES, LTD.),<br>10 November, 1999 (10.11.99),<br>Claims; examples<br>& JP 2961103 B1<br>Claims; examples<br>& AU 9912141 A & US 2002/000201 A1<br>& DE 69906180 E | 1,2,3,11,12<br>4,6<br>5,7-10 |
| X<br>Y<br>A | JP 2000-58465 A (MITSUBISHI HEAVY INDUSTRIES, LTD.),<br>25 February, 2000 (25.02.00),<br>Par. Nos. [0012] to [0020], [0043] to [0046]<br>& EP 961307 A1 & AU 9917371 A<br>& KR 99087863 A | 1,2,3,11,12<br>4,6<br>5,7-10 |

☒ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>25 December, 2003 (25.12.03) | Date of mailing of the international search report<br>20 January, 2004 (20.01.04) |
| Name and mailing address of the ISA/<br>Japanese Patent Office | Authorized officer |
| Facsimile No. | Telephone No. |

Form PCT/ISA/210 (second sheet) (July 1998)

## INTERNATIONAL SEARCH REPORT

International application No.
PCT/JP03/12563

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2816365 B2 (Kabushiki Kaisha Yuha Mikakuto Seimitsu Kogaku Kenkyusho), 27 October, 1998 (27.10.98), Column 13, lines 34 to 47; Fig. 1 (Family: none) | 4,6 |
| A | JP 2001-274099 A (MITSUBISHI HEAVY INDUSTRIES, LTD.), 05 October, 2001 (05.10.01), Full text & US 2001/021422 A1 & AU 200111108 A & EP 1134773 A & KR 2001091880 A & TW 507256 A | 1-12 |
| A | JP 2001-7028 A (MITSUBISHI HEAVY INDUSTRIES, LTD.), 12 January, 2001 (12.01.01), Full text & WO 00/79844 A1 & AU 200052496 A & EP 1107653 A1 & KR 2001072478 A & TW 451306 A & US 6417079 B1 | 1-12 |
| A | JP 2001-321662 A (Nihon Koshuha Co., Ltd.), 20 November, 2001 (20.11.01), Full text (Family: none) | 1-12 |

Form PCT/ISA/210 (continuation of second sheet) (July 1998)